# EUROPÄISCHE PATENTSCHRIFT

(11) **EP 4 128 524 B1**
(45) Veröffentlichungstag und Bekanntmachung des Hinweises auf die Patenterteilung: **18.06.2025**
(21) Anmeldenummer: 21716721.2
(22) Anmeldetag: 01.04.2021
(51) Int. Cl.: H02P 29/024, H02H 7/08, H02H 7/122, H03K 17/082, B62D 5/04

(54) **VERFAHREN ZUM SCHUTZ EINES SICHERHEITSSCHALTERS EINER STEUEREINHEIT EINES ELEKTROMOTORS, SOWIE ELEKTROMECHANISCHE KRAFTFAHRZEUGLENKUNG**
METHOD FOR PROTECTING A SAFETY SWITCH OF A CONTROL UNIT OF AN ELECTRIC MOTOR, AND ELECTROMECHANICAL VEHICLE STEERING
PROCÉDÉ DE PROTECTION D'UN COMMUTATEUR DE SÉCURITÉ D'UNE UNITÉ DE COMMANDE D'UN MOTEUR ÉLÉCTRIQUE, ET DIRECTION ÉLECTROMÉCANIQUE DE VÉHICULES

(30) Priorität: 03.04.2020 DE 102020109438
(43) Veröffentlichungstag der Anmeldung: 08.02.2023
(73) Patentinhaber: thyssenkrupp Presta AG, 9492 Eschen (LI); thyssenkrupp AG, 45143 Essen (DE)
(72) Erfinder: KALAPOS, Gábor, 2230 Gyömro (HU)
(74) Vertreter: thyssenkrupp Intellectual Property GmbH
(86) Internationale Anmeldenummer: PCT/EP2021/058718
(87) Internationale Veröffentlichungsnummer: WO 2021/198471

(56) Entgegenhaltungen:
- EP-A1- 3 157 163
- DE-A1- 102011 055 626
- DE-A1- 102017 211 219
- DE-T5- 112015 003 702

## Beschreibung

Die vorliegende Erfindung betrifft ein Verfahren zum Schutz von Sicherheitsschalter einer Steuereinheit eines Elektromotors mit den Merkmalen des Oberbegriffs des Anspruchs 1 und eine elektromechanische Kraftfahrzeuglenkung.

Elektromechanische Lenkungen weisen üblicherweise einen permanent erregten Synchronmotor als Servomotor auf. Servomotoren dieser Bauart werden von einer Steuerung über einen Satz von MOSFETs angesteuert, wobei bei drei Phasenwicklungen insgesamt sechs MOSFETs vorgesehen sind. Je ein MOSFET schaltet die zugeordnete Phasenwicklung auf die Bordspannung oder das Massepotential. Dieses erfolgt mit hoher Frequenz, so dass in der Phasenwicklung der zeitliche Mittelwert als Effektivspannung wirkt.

Permanent erregte Synchronmotoren haben die Eigenschaft, bei elektrischen Fehlern wie beispielsweise bei Kurzschlüssen im Motor oder in der Ansteuerung ein Bremsmoment zu erzeugen, so dass ein derartiger Fehler nicht nur zu einem Ausfall der Lenkunterstützung führen kann, sondern der Lenkbewegung des Fahrers auch noch ein zusätzlicher Widerstand entgegengesetzt wird. Dies ist bei Lenksystemen für Kraftfahrzeuge aus Sicherheitsgründen nicht tolerierbar.

Es ist bekannt, zur Vermeidung dieses Zustandes eine Auftrennung der Phasenzuleitungen zum Motor oder im Sternpunkt des Motors vorzunehmen.

Hierzu werden im Stand der Technik als Sicherheitsschalter fungierende Halbleiterschalter vorgeschlagen, die jeweils zwischen einem Ende der Phasenwicklung und der Treiberschaltung des Motors in Reihe geschaltet sind. Dabei kann es bei dem Öffnen der Schaltelemente aufgrund der stets vorhandenen Streuinduktivitäten in dem Wechselrichter und aufgrund der in den Motorwicklungen gespeicherten elektrischen Energie zu Überspannungen kommen. Wird der Stromfluss durch einen Halbleiterschalter unterbrochen, so steigt an dem Halbleiterschalter zwischen Drain und Source die Spannung auf einen Wert, der größer sein kann, als die Versorgungsspannung. Überschreitet die dabei auftretende Spannung die maximale Sperrspannung des Halbleiterschalters, so kann es zur Zerstörung des Halbleiterschalters kommen. Ein zu hoher Stromfluss durch den Sicherheitsschalter während des Ausschaltens muss daher vermieden werden, um den Halbleiterschalter vor Beschädigung zu schützen.

Bekannt ist zudem aus der DE 10 2011 055 626 A1 ein Verfahren zum Unterbrechen einer Phasenleitung eines elektrischen Antriebsmotors eines Lenksystems. Dabei wird der Momentanstrom der Phasenleitung gemessen und ein Trennschalter zum Unterbrechen der Phasenleitung angesteuert, wenn der Momentanstrom unterhalb eines Schwellwerts liegt. Die DE 10 2011 055 626 A1 offenbart dabei eine Steuereinheit des Antriebsmotors mit einem Mikrocontroller und einem Gate-Treiber sowie einer Treiberschaltung mit einer Mehrzahl von in Halbbrücken angeordneten Feldeffekttransistoren. Die Information, welcher Transistor defekt beziehungsweise kurzgeschlossen ist, wird dabei über eine Diagnose durch den Endstufentreiber oder durch Rücklesen der Motorphasenspannungen erhalten.

Ferner offenbart die DE 10 2017 211 219 A1 ein Verfahren zum Betreiben eines Motorsystems mit einer elektrischen Maschine, wobei eine Leistungstreiberschaltung zum Bereitstellen von Phasenspannungen und eine Sicherheitseinrichtung zum Auftrennen von Phasenstrangzuleitungen, die die Leistungstreiberschaltung mit Phasensträngen der elektrischen Maschine verbinden, vorgesehen ist. In einem Fehlerfall werden dabei die Fehlerart, die Drehrichtung der elektrischen Maschine, die Drehzahl der elektrischen Maschine und ein drehzahlabhängiger Referenz-Rotorlagebereich bestimmt. Zudem wird ein Rotorlagebereich ermittelt, in dem - abhängig von der Drehrichtung und der Fehlerart - eine gleichzeitige Auftrennung der Phasenstränge erfolgen kann.

Die DE 11 2015 003 702 T5 offenbart ebenfalls ein Verfahren zum Betreiben eines mehrphasigen Elektromotors, wobei jede Phase durch ein Relais mit einem Brückentreiber verbunden ist. Beim Eintritt eines Fehlerereignisses wird ein Zeitpunkt bestimmt, zu dem der Strom in der jeweiligen Phase einen Pegel erreicht hat, der ein beschädigungsfreies Öffnen des Relais ermöglicht.

Ein ähnliches Verfahren wird auch in der EP 3 157 163 A1 beschrieben, wobei im Fehlerfall die in dem Motor vorhandene Energie bestimmt wird, und beim Unterschreiten eines Referenzwerts für die Energie ebenfalls ein entsprechendes Relais geöffnet wird.

Es ist Aufgabe der vorliegenden Erfindung ein Verfahren und eine elektromechanische Kraftfahrzeuglenkung zum Schutz der Sicherheitsschalter anzugeben, wobei Beschädigungen von Sicherheitsschaltern beim Auftrennen der Leitung verhindert werden.

Diese Aufgabe wird von einem Verfahren mit den Merkmalen des Anspruchs 1 und einer elektromechanischen Kraftfahrzeuglenkung mit den Merkmalen des Anspruchs 12 gelöst. Vorteilhafte Ausgestaltungen der Lösungen ergeben sich aus den Unteransprüchen sowie aus der Beschreibung und den in den Figuren gezeigten Ausführungsbeispielen.

Demnach ist ein Verfahren zum Schutz von Sicherheitsschaltern einer Steuereinheit eines Elektromotors vorgesehen, wobei die Steuereinheit einen Mikrokontroller und einen Gate-Treiber aufweist, die eine Treiberschaltung mit 2n FETs (FET: Feldeffekttransistor) ansteuern, wobei n die Anzahl an Phasenwicklungen des Elektromotors ist und die FETs in Halbbrücken angeordnet sind, und im Mittenabgriff einer jeden Halbbrücke, zwischen Treiberschaltung und Phasenwicklung des Elektromotors ein Sicherheitsschalter angeordnet ist. Die Sicherheitsschalter sind FETs und dazu eingerichtet, die elektrische Verbindung zwischen der Treiberschaltung und einer jeden Phasenwicklung im Störfall zu unterbrechen. Das Verfahren umfasst im Fall einer elektrischen Störung in der Treiberschaltung folgende Schritte:
a) Aktivieren eines der 2n FETs der Treiberschaltung,
b) Messen des Stromflusses in einer Versorgungsleitung der Treiberschaltung und Erfassen eines Stromwertes,
c) Deaktivieren des aktivierten FETs der Treiberschaltung,
d) nacheinander Ausführen eines Prüf-Schaltmusters entsprechend der Schritte a) bis c) für die verbliebenen 2n-1 FETs, also beispielsweise bei sechs FETs für die verbliebenen fünf FETs, wobei jeweils zu Beginn der Ausführung des Prüf-Schaltmusters alle FETs deaktiviert sind,
e) Auswerten der erfassten Stromwerte bezüglich eines Unterschreitens eines vorgegebenen Schwellenwerts, wobei der höchste erfasste Stromwert unberücksichtigt bleibt,
f) Bei einem Unterschreiten des Schwellwerts, Trennen der elektrischen Verbindung zwischen der Treiberschaltung und mindestens einer der Phasenwicklungen durch Schalten der Sicherheitsschalter.

Dieses Verfahren greift vorteilhafterweise ausschließlich auf bereits bestehende Hardware zurück. Die Messung des Stromflusses wird vorteilhafterweise genutzt, um einen Zeitpunkt zu finden, in dem der Strom der Sicherheitsschalter unter dem Schwellwert ist und somit der Sicherheitsschalter ohne Beschädigung geöffnet werden kann. Das Verfahren ist daher sehr kostengünstig und kann in jedem Elektromotor eingesetzt werden, bei dem es wichtig ist, die Sicherheitsschalter vor Beschädigung zu schützen. Die FETs sind bevorzugt MOSFETs.

Nach dem erfindungsgemäßen Verfahren werden die Verfahrensschritte a) bis f) erneut ausgeführt, wenn der Schwellwert nicht unterschritten wird, der Schwellwert also überschritten oder genau getroffen wird. Das Öffnen der Sicherheitsschalter wird insofern vorteilhafterweise weiter hinausgezögert, bis die für die Sicherheitsschalter kritischen Ströme unterschritten sind.

Gemäß einer vorteilhaften Ausgestaltung liegt zwischen dem Aktivieren eines FETs und dem Deaktivieren dieses FETs ein vorgegebenes Zeitintervall, insbesondere ein Zeitintervall zwischen 0,5 µs (µs: Mikrosekunde) und 2 ms (ms: Millisekunde), weiter insbesondere ein Zeitintervall zwischen 1 µs und 1 ms, weiter insbesondere ein Zeitintervall zwischen 1 µs und 10 µs. Ein möglichst kurzes Zeitintervall hat sich dabei als besonders vorteilhaft erwiesen.

Eine weitere vorteilhafte Ausgestaltung des Verfahrens sieht vor, dass beim Auswerten der erfassten Stromwerte der zweithöchste Stromwert und der dritthöchste Stromwert aus den erfassten Stromwerten ermittelt wird. Der zweithöchste Stromwert und der dritthöchste Stromwert können dabei auch gleich groß sein. Aus den Werten des zweithöchsten Stromwertes und des dritthöchsten Stromwertes wird dann vorteilhafterweise ein Summenwert gebildet und der Summenwert mit dem vorgegebenen Schwellenwert verglichen. Dieser Schritt entspricht dann vorteilhafterweise dem Auswerten der erfassten Stromwerte bezüglich eines Unterschreitens eines vorgegebenen Schwellenwerts und ist insofern eine speziellere Ausgestaltung des Verfahrensschritts e). Durch die Summenbildung lässt sich vorteilhafterweise zuverlässiger ermitteln, ob die Sicherheitsschalter geöffnet werden können, insbesondere weil Ausreißer bei den Messwerten weniger ins Gewicht fallen.

Insbesondere ist vorgesehen, dass der Schwellenwert abhängig von den elektrischen Eigenschaften des Sicherheitsschalters vorgegeben ist. Vorzugweise ist der Schwellenwert abhängig von der Kapazität des Sicherheitsschalters.

Das gemessene Stromsignal kann dazu ausgewertet werden, um die elektrische Störung eines FETs in der Treiberschaltung zu lokalisieren und den elektrischen Widerstandswert des gestörten FETs zu bestimmen.

Vorzugweise erfolgt die Ansteuerung mit dem Prüf-Schaltmuster bei hohen Rotorwinkelgeschwindigkeiten in Abhängigkeit vom elektrischen Winkel des Elektromotors, wobei der elektrische Winkel mittels eines Rotorlagesensors bestimmt wird.

Bei niedrigen Rotorwinkelgeschwindigkeiten kann die Ansteuerung mit dem Prüf-Schaltmuster in Zeitabständen asynchron zu dem elektrischen Winkel des Elektromotors erfolgen, wobei der elektrische Winkel insbesondere nicht berücksichtigt wird.

Die Body-Diode der Sicherheitsschalter kann in Durchlassrichtung oder in Sperrrichtung geschaltet sein.

Die ebenfalls vorgeschlagene elektromechanische Kraftfahrzeuglenkung umfasst einen mehrphasigen, permanent erregten Elektromotor, der über eine Steuereinheit und Zuleitungen aus einem Gleichspannungsbordnetz eines Kraftfahrzeugs betreibbar ist, wobei der Elektromotor mindestens drei Phasenwicklungen aufweist, die über Leitungen mit einer Treiberschaltung verbunden sind, wobei die Treiberschaltung jede der Leitungen über jeweils einen ersten FET einer ersten Gruppe mit der positiven Zuleitung und über jeweils einen zweiten FET einer zweiten Gruppe mit der negativen Zuleitung in Abhängigkeit von der Steuereinheit verbindet, und wobei jede Leitung einen FET als Sicherheitsschalter aufweist, und die Steuereinheit dazu ausgebildet ist, dass zuvor beschriebene Verfahren auszuführen, wobei die vorstehend beschriebenen Ausgestaltungen und Weiterbildungen des Verfahrens insbesondere einzeln oder in Kombination realisiert sein können. Die Steuereinheit weist bevorzugt eine Entscheidungseinheit auf, die basierend auf dem gemessenen Stromsignal entscheidet, ob die Sicherheitsschalter sicher geöffnet werden können, oder nicht.

Vorteilhafte Ausführungsformen der Erfindung werden nachfolgend anhand der Zeichnungen näher erläutert. Gleiche bzw. funktionsgleiche Bauteile sind dabei figurübergreifend mit denselben Bezugszeichen versehen. Es zeigen:
- Fig. 1:: eine elektromechanische Kraftfahrzeuglenkung in einer schematischen Darstellung mit mehreren Möglichkeiten zur Anordnung des Servomotors,
- Fig. 2:: eine erste Schaltung zur Ansteuerung eines permanent erregten Synchronmotors mit sechs FETs zur Steuerung des Motorstroms,
- Fig. 3:: eine zweite Schaltung zur Ansteuerung eines permanent erregten Synchronmotors mit sechs FETs zur Steuerung des Motorstroms,
- Fig. 4:: die erste Schaltung der Figur 2 mit einem kurzgeschlossenen FET,
- Fig. 5:: ein Diagramm der typischen Phasenkurzschlussströme und der Einfluss eines Prüfschaltmusters,
- Fig. 6:: ein Verlauf des Stromwertes bei der Aktivierung zum Zeitpunkt #1 aus Fig. 5, sowie
- Fig. 7:: ein Verlauf des Stromwertes bei der Aktivierung zum Zeitpunkt #2 aus Fig. 5.

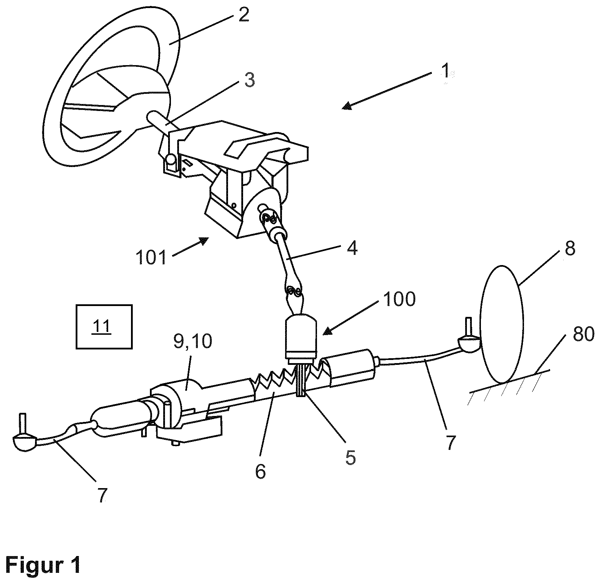

In der Figur 1 ist eine elektromechanische Kraftfahrzeugservolenkung 1 mit einem Lenkrad 2, das mit einer oberen Lenkwelle 3 drehfest gekoppelt ist, schematisch dargestellt. Über das Lenkrad 2 bringt der Fahrer ein entsprechendes Drehmoment als Lenkbefehl in die Lenkwelle 3 ein. Das Drehmoment wird dann über die obere Lenkwelle 3 und untere Lenkwelle 4 auf ein Lenkritzel 5 übertragen. Das Ritzel 5 kämmt in bekannter Weise mit einem Zahnsegment einer Zahnstange 6. Die Zahnstange 6 ist in einem Lenkungsgehäuse in Richtung ihrer Längsachse verschieblich gelagert. An ihrem freien Ende ist die Zahnstange 6 mit Spurstangen 7 über nicht dargestellte Kugelgelenke verbunden. Die Spurstangen 7 selbst sind in bekannter Weise über Achsschenkel mit je einem gelenkten Rad 8 des Kraftfahrzeugs verbunden. Eine Drehung des Lenkrades 2 führt über die Verbindung der Lenkwelle 3 und des Ritzels 5 zu einer Längsverschiebung der Zahnstange 6 und damit zu einer Verschwenkung der gelenkten Räder 8. Die gelenkten Räder 8 erfahren über eine Fahrbahn 80 eine Rückwirkung, die der Lenkbewegung entgegenwirkt. Zum Verschwenken der Räder 8 ist folglich eine Kraft erforderlich, die ein entsprechendes Drehmoment am Lenkrad 2 erforderlich macht. Ein Elektromotor 9 einer Servoeinheit 10 ist vorgesehen, um den Fahrer bei dieser Lenkbewegung zu unterstützen. Die obere Lenkwelle 3 und die untere Lenkwelle 4 sind drehelastisch über einen nicht gezeigten Drehstab miteinander gekoppelt. Eine Drehmomentsensoreinheit erfasst die Verdrehung der oberen Lenkwelle 3 gegenüber der unteren Lenkwelle 4 als ein Maß des an der Lenkwelle 3 oder des Lenkrades 2 manuell ausgeübten Drehmomentes. In Abhängigkeit des von der Drehmomentsensoreinheit gemessen Drehmoments berechnet eine in Figur 1 nur schematisch dargestellte Steuereinheit 11 die Lenkunterstützung, die von der Servoeinheit 10 für den Fahrer bereitgestellt wird. Die Servoeinheit 10 kann dabei als Hilfskraftunterstützungseinrichtung 10, 100, 101 entweder mit einer Lenkwelle 3, dem Lenkritzel 5 oder der Zahnstange 6 gekoppelt sein. Die jeweilige Hilfskraftunterstützung 10, 100, 101 trägt ein Hilfskraftmoment in die Lenkwelle 3, das Lenkritzel 5 und/oder in die Zahnstange 6 ein, wodurch der Fahrer bei der Lenkarbeit unterstützt wird. Die drei unterschiedlichen in Figur 1 dargestellten Hilfskraftunterstützungseinrichtungen 10, 100, 101 zeigen insbesondere alternative Positionen für deren Anordnung. Üblicherweise ist nur eine einzige der gezeigten Positionen mit einer Hilfskraftunterstützung belegt.

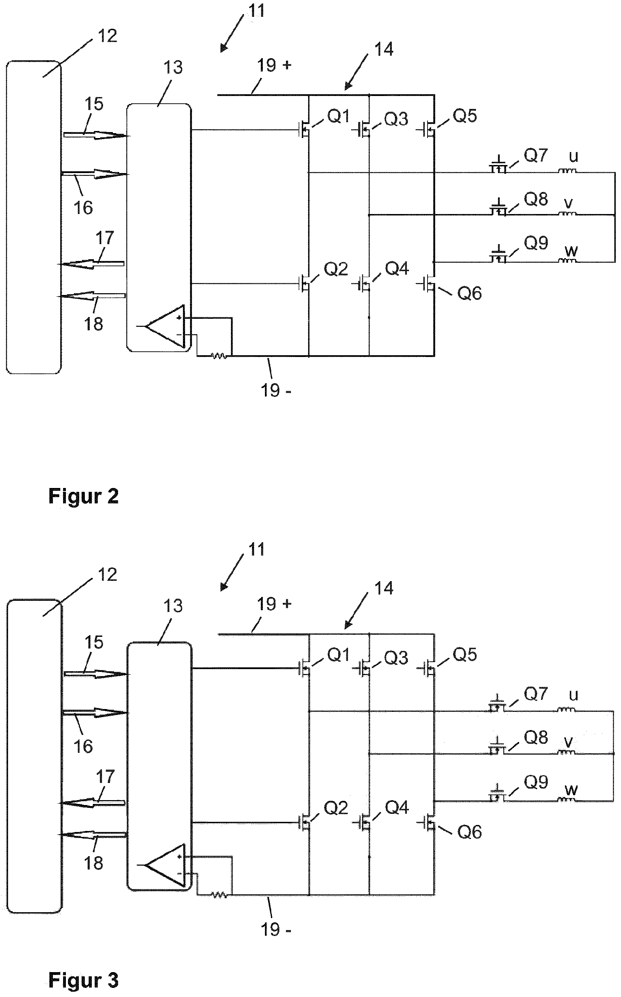

Die Figuren 2 und 3 zeigen Ausführungsbeispiele für eine Steuereinheit 11 des Elektromotors 9. Ein Mikrokontroller 12 steuert mittels eines Gate-Treibers 13 eine Treiberschaltung 14 an. Der Mikrokontroller 12 sendet ein PWM Signal 15 und ein SPI Konfigurationssignal 16 an den Gate Treiber 13. Der Gate Treiber 13 wiederrum sendet ein Diagnosesignal 17 und Messwerte einer Strommessung 18 an den Mikrokontroller 12. Die Versorgungsleitung 19+ ist dem positiven Pol der Versorgungsleitung, die Versorgungsleitung 19- ist mit dem negativen Pol der Versorgungsleitung oder dem Masseanschluss der Bordelektrik des Kraftfahrzeugs verbunden, die in üblicher Weise mit Gleichspannung mit negativer Masse arbeitet.

Eine erste Gruppe von FETs umfasst drei FETs Q1, Q3 und Q5 zur Beaufschlagung der drei Phasenwicklungen u, v und w mit der Bordspannung. Eine zweite Gruppe von insgesamt drei weiteren FETs Q2, Q4 und Q6 ist für die Beaufschlagung der Phasenwicklungen u, v und w mit dem Massepotential vorgesehen. Die beiden Gruppen speisen hierfür insgesamt drei Leitungen, die jeweils einer Phase u, v, w zugeordnet sind.

Die FETs der ersten Gruppe und der zweiten Gruppe sind als Treiber vorgesehen und bilden die Treiberschaltung 14 aus.

Jedem Wicklungsstrang u, v, w ist somit ein oberer elektronischer Schalter Q1, Q3, Q5 (high-side) und ein unterer elektronischer Schalter Q2, Q4, Q6 (lowside) zugeordnet. Diese Treiber-FETs sind üblicherweise so geschaltet, dass ihre Body-Dioden bezüglich der Bordspannung in Sperrrichtung geschaltet sind. In Abhängigkeit von den Steuersignalen verbinden die FETs die einzelnen Phasenwicklungen u, v und w entweder mit dem positiven Potenzial oder mit dem Massepotenzial. Dies erfolgt mit hoher Frequenz, so dass in den einzelnen Wicklungen u, v und w der zeitliche Mittelwert als Betriebsspannung zur Erzeugung eines Unterstützungsmoments wirksam ist.

In den drei Leitungen zu den Phasenwicklungen hin ist jeweils ein FET einer dritten Gruppe als Sicherheitsschalter Q7, Q8, Q9 vorgesehen. Die Sicherheitsschalter Q7, Q8, Q9 sind somit zwischen der Treiberschaltung 14 und den Motorwicklungen u, v, w vorgesehen. Im Falle einer elektrischen Störung sollen diese Sicherheitsschalter Q7, Q8, Q9 die elektrische Verbindung zwischen der Treiberschaltung und den Wicklungen auftrennen. Die Wicklungen sind dann nicht kurzgeschlossen und können kein Bremsmoment erzeugen.

Im Ausführungsbeispiel der Figur 2 handelt es sich bei den Sicherheitsschaltern Q7, Q8, Q9 um n-Kanal FETs, die selbstleitend sind. Der Drain-Anschluss ist mit der Treiberschaltung 14 und der Source-Anschluss mit der Phasenwicklung u, v, w verbunden.

Dagegen ist in dem Ausführungsbeispiel der Figur 3, der Drain-Anschluss der Sicherheitsschalter Q7, Q8, Q9 mit der Phasenwicklung u, v, w und der Source-Anschluss mit der Treiberschaltung Q7, Q8, Q9 verbunden.

Die zwischen Drain- und Source-Anschluss liegende Body-Diode der Sicherheitsschalter Q7, Q8, Q9 kann sowohl in Durchlassrichtung oder in Sperrrichtung geschaltet sein.

Jeder der neun dargestellten Halbleiterschalter Q1, Q2, Q3, Q4, Q5, Q6, Q7, Q8, Q9 ist bevorzugter Weise separat mittels des Gate-Treibers 13 ansteuerbar.

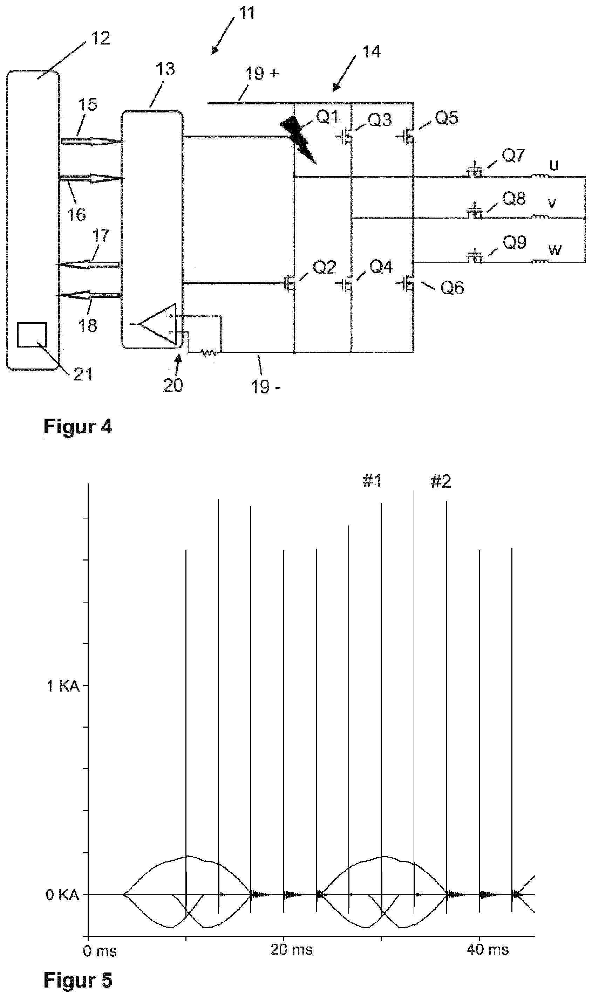

Figur 4 zeigt einen Störungsfall in dem Ausführungsbeispiel der Figur 2. Der FET Q1 der Treiberschaltung 14 ist kurzgeschlossen.

Für den Fall, dass eine solche elektrische Störung erkannt wird und die Sicherheitsschalter Q7, Q8, Q9 die elektrische Verbindung zwischen der Treiberschaltung 14 und den Wicklungen u, v, w auftrennen sollen, sendet der Hauptmikrokontroller 12 der Steuereinheit 11 ein spezielles Prüf-Schaltmuster aus. Dieses Schaltmuster bewirkt eine sehr kurze aufeinanderfolgende Aktivierung der FETs Q1, Q2, Q3, Q4, Q5, Q6 der Treiberschaltung 14. In den Ausführungsbeispielen der Figuren 2 und 3 heißt das, dass als erstes Q1 und dann Q2, Q3, Q4, Q5 und Q6 in der genannten Reihenfolge für ein paar µs (µs: Mikrosekunden) aktiviert werden. Insbesondere ist vorgesehen, dass vor dem Aktivieren eines nächsten FETs der vorherige FET deaktiviert wird. Wird also beispielsweise FET Q1 aktiviert, so wird FET Q1 vor der Aktivierung von FET Q2 deaktiviert.

Während der Aktivierungszeiten wird der über die Versorgungsleitung 19-fließende Strom von einem Analog-Digital-Wandler 20 gemessen, und mit den Aktivierungen synchronisiert.

Diese abgetasteten Stromwerte dienen als Eingangswerte für eine Entscheidungseinheit 21 des Mikrokontrollers 12, die entscheidet, ob die Sicherheitsschalter Q7, Q8, Q9 die elektrische Verbindung auftrennen oder nicht.

Ein Auftrennen kann problemlos erfolgen, wenn der Drainstrom der Sicherheitsschalter Q7, Q8, Q9 kleiner als ein vorgebbarer Schwellwert ist, um den Sicherheitsschalter Q7, Q8, Q9 selbst vor Beschädigung zu schützen.

Figur 5 zeigt einen typischen zeitlichen Verlauf eines Kurzschlussstroms in einer Phase und die Beeinflussung durch das Prüf-Schaltmuster. Die senkrechten Striche geben die zeitlichen Abstände an, an denen das Prüf-Schaltmuster jeweils geschaltet wird. Die Höhe dieser Striche zeigt den gemessenen Stromfluss an. Die Bögen geben die Wicklungsströme an.

Die Ansteuerung mit dem Prüf-Schaltmuster erfolgt bei hohen Rotorwinkelgeschwindigkeiten bevorzugt in Abhängigkeit vom elektrischen Winkel des Motors. Ein Rotorlagesensor wird dazu verwendet, einen mechanischen Winkel zu messen und daraus den elektrischen Winkel zu bestimmen.

Der Elektromotor weist bevorzugt drei Phasenwicklungen auf. Der Kommutierungswinkel, d. h. der Winkel bezüglich der vollen elektrischen Welle während dem eine Phasenwicklung bestromt ist, beträgt 120°. Im Fall eines Kurzschlusses erfolgt die Ansteuerung mit dem Prüf-Schaltmuster etwa alle 60°.

Bei niedrigen Rotorwinkelgeschwindigkeiten kann die Ansteuerung mit dem Prüf-Schaltmuster in Zeitabständen asynchron zu dem elektrischen Winkel erfolgen.

Innerhalb eines Durchlaufens einer kompletten elektrischen Periode kann zudem der ideale Zeitpunkt zum Öffnen der Sicherheitsschalter unabhängig von den zuvor genannten Triggermethoden gefunden werden.

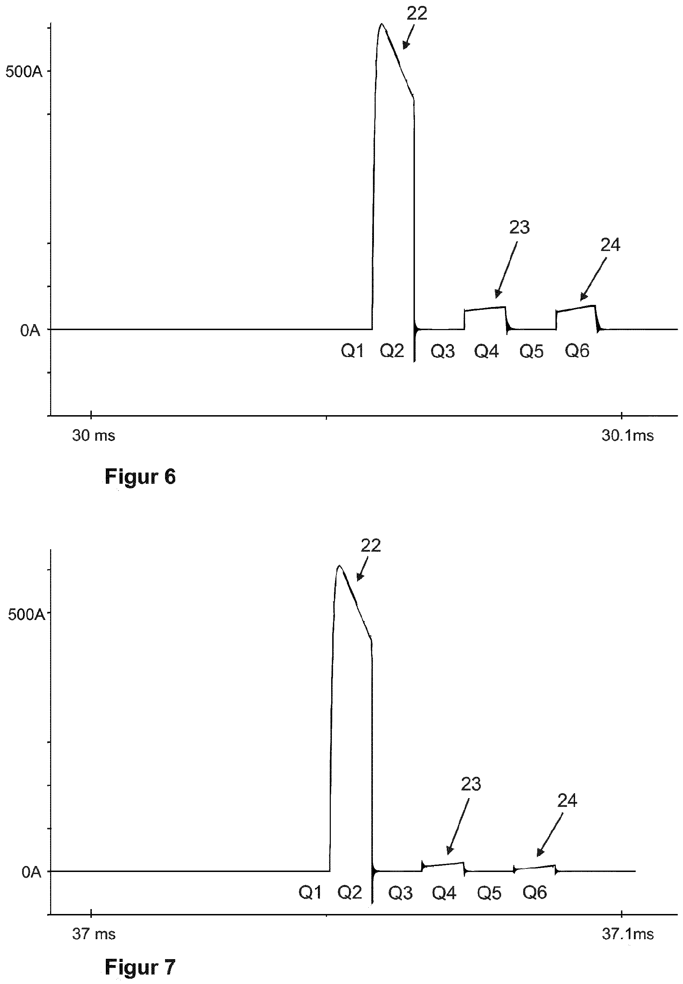

Die Figuren 6 und 7 zeigen zeitliche Verläufe des gemessenen Stroms jeweils während eines Prüf-Schaltmusters. Der höchste gemessene Strom 22 ist der Strom, der über den kurzgeschlossenen FET und den gerade aktivierten FET derselben Halbbrücke fließt. In dem Beispiel der Figur 4 ist dieses globale Maximum dem defekten FET Schalter Q1 und dem aktivierten FET Schalter Q2 zuzuordnen.

Die Figur 6 zeigt den Verlauf des gemessenen Stroms in einem ersten Prüf-Schaltmuster-Zyklus #1, wie in Figur 5 gekennzeichnet. In der Figur 7 ist der Verlauf des gemessenen Stroms in einem zweiten Prüf-Schaltmuster-Zyklus #2 dargestellt. Der Strom wird jeweils gemessen kurz bevor ein FET deaktiviert wird.

Wird, bezogen auf das vorstehend beschriebene Ausführungsbeispiel, FET Q1 geschaltet, so wird, wie in Figur 6 und Figur 7 gezeigt, kein Strom erfasst, also ein Strom von 0 A (A: Ampere) oder zumindest näherungsweise 0 A erfasst, da die anderen FETs kurzschlussfrei und geöffnet sind, also deaktiviert sind, und somit kein Strom zwischen Motor und Massepotenzial 19- fließen kann. Wird dann FET Q2 aktiviert, so ist aufgrund des Kurzschlusses in Q1 eine direkte Verbindung zwischen der positiven Zuleitung 19+ und dem Massepotenzial 19-, wodurch sich das Strommaximum 22 erklärt. Wird nun FET Q2 deaktiviert, also der FET elektrisch nichtleitend geschaltet, und FET Q3 aktiviert, so kann wiederum kein Strom zwischen Motor und Massepotenzial 19- fließen, sodass ein Stromwert von 0 erfasst wird, wie in Figur 6 und Figur 7 gezeigt. Wird FET Q3 deaktiviert und FET Q4 aktiviert, so kann aufgrund der in den Motorwicklungen gespeicherten elektrischen Energie ein Strom zwischen Motor und Massepotenzial 19- fließen und es wird ein Stromwert entsprechend dem dargestellten zweiten Maximum erfasst. Nach der Strommessung wird FET Q4 dann wiederum deaktiviert und FET Q5 aktiviert. Hier ist wiederum kein Stromfluss möglich und der Stromwert beträgt entsprechend 0. Nach dem Deaktivieren von FET Q5 wird dann FET Q6 aktiviert. Aufgrund der in den Motorwicklungen gespeicherten elektrischen Energie fließt ein Strom zwischen Motor und Massepotenzial 19- und es wird ein Stromwert entsprechend dem dargestellten dritten Maximum 24, das in der Höhe etwa dem zweiten Maximum 23 entspricht, erfasst. Da Figur 7 den Stromverlauf zu einem späteren Zeitpunkt zeigt, als Figur 6, fallen hier das zweite Maximum 23 und das vierte Maximum 24 geringer aus.

Die erfassten Stromwerte des zweithöchsten Maximums 23 und des dritthöchsten Maximums 24 werden addiert. Im Beispiel des defekten FET Schalters Q1 ist, wie vorstehend beschrieben, das zweithöchste Maximum 23 dem FET Schalter Q4 und das dritthöchste lokale Maximum 24 dem FET Schalter Q6 zuzuordnen.

Anhand einer Auswertung des Summenwertes wird entschieden, ob die Sicherheitsschalter Q7, Q8, Q9 die elektrische Verbindung auftrennen oder nicht. Falls der Summenwert niedriger ist als ein vorgegebener, von der Kapazität des Sicherheitsschalters Q7, Q8, Q9 abhängiger Schwellenwert, können alle Sicherheitsschalter Q7, Q8, Q9 zur gleichen Zeit geöffnet werden. Zudem kann anhand des zeitlichen Verlaufs des in der Versorgungsleitung gemessenen Stroms der kurzgeschlossene FET lokalisiert und dessen elektrischer Widerstandswert bestimmt werden.

Im Prüf-Schaltmuster-Zyklus #1 ist der Summenwert hoch und höher als der Schwellenwert, so dass die Sicherheitsschalter Q7, Q8, Q9 die elektrische Verbindung nicht trennen können, ohne Schaden zu nehmen. Die Entscheidungseinheit 21 entscheidet daher, dass die Sicherheitsschalter Q7, Q8, Q9 nicht geöffnet werden. Im Prüf-Schaltmuster-Zyklus #2 ist der Summenwert hingegen niedrig genug, so dass der Schwellenwert unterschritten ist und die Sicherheitsschalter Q7, Q8, Q9 alle geöffnet werden können, ohne beschädigt zu werden.

Das zuvor beschriebene Verfahren kann auch in Steer-by-Wire-Lenksystemen eingesetzt werden.

## Patentansprüche

1. Verfahren zum Schutz von Sicherheitsschaltern (Q7, Q8, Q9) einer Steuereinheit (11) eines Elektromotors (9), wobei die Steuereinheit (11) einen Mikrokontroller (12) und einen Gate-Treiber (13) aufweist, die eine Treiberschaltung (14) mit 2n FETs (Q1, Q2, Q3, Q4, Q5, Q6) ansteuern, wobei n die Anzahl an Phasenwicklungen (u, v, w) des Elektromotors (9) ist und die FETs (Q1, Q2, Q3, Q4, Q5, Q6) in Halbbrücken angeordnet sind, und im Mittenabgriff einer jeden Halbbrücke, zwischen Treiberschaltung (14) und Phasenwicklung (u, v, w) des Elektromotors (9) der Sicherheitsschalter (Q7, Q8, Q9) angeordnet ist, wobei die Sicherheitsschalter (Q7, Q8, Q9) FETs sind, die dazu eingerichtet sind, die elektrische Verbindung zwischen der Treiberschaltung (14) und einer jeden Phasenwicklung (u, v, w) im Störfall zu unterbrechen, **dadurch gekennzeichnet, dass** das Verfahren im Fall einer elektrischen Störung in der Treiberschaltung (14) folgende Schritte umfasst:
a) Aktivieren eines der 2n FETs (Q1, Q2, Q3, Q4, Q5, Q6) der Treiberschaltung (14),
b) Messen des Stromflusses in einer Versorgungsleitung (19-) der Treiberschaltung (14) und Erfassen eines Stromwertes,
c) Deaktivieren des aktivierten FETs (Q1, Q2, Q3, Q4, Q5, Q6) der Treiberschaltung (14),
d) nacheinander Ausführen eines Prüf-Schaltmusters entsprechend der Schritte a) bis c) für die verbliebenen 2n-1 FETs (Q1, Q2, Q3, Q4, Q5, Q6), wobei zu Beginn der Ausführung des Prüf-Schaltmusters alle FETs deaktiviert sind,
e) Auswerten der erfassten Stromwerte bezüglich eines Unterschreitens eines vorgegebenen Schwellenwerts, wobei der höchste erfasste Stromwert (22) unberücksichtigt bleibt,
f) bei einem Unterschreiten des Schwellwerts, Trennen der elektrischen Verbindung zwischen der Treiberschaltung (14) und mindestens einer der Phasenwicklungen (u, v, w) durch Schalten der Sicherheitsschalter (Q7, Q8, Q9),
wobei die Verfahrensschritte a) bis f) erneut ausgeführt werden, wenn der Schwellwert nicht unterschritten wird.

2. Verfahren nach Anspruch 1, **dadurch gekennzeichnet, dass** zwischen dem Aktivieren eines FETs (Q1, Q2, Q3, Q4, Q5, Q6) und dem Deaktivieren dieses FETs (Q1, Q2, Q3, Q4, Q5, Q6) ein vorgegebenes Zeitintervall, insbesondere ein Zeitintervall zwischen 1 µs und 1 ms, liegt.

3. Verfahren nach einem der vorstehenden Ansprüche, **dadurch gekennzeichnet, dass** beim Auswerten der erfassten Stromwerte der zweithöchsten Stromwert (23) und der dritthöchste Stromwert (24) aus den erfassten Stromwerten ermittelt wird; ein Summenwert aus den Werten des zweithöchsten Stromwertes (23) und des dritthöchsten Stromwertes (24) gebildet wird; und der Summenwert mit dem vorgegebenen Schwellenwert bei der Auswertung verglichen wird.

4. Verfahren nach einem der vorstehenden Ansprüche, **dadurch gekennzeichnet, dass** der Schwellenwert abhängig von den elektrischen Eigenschaften des Sicherheitsschalters (Q7, Q8, Q9) ist.

5. Verfahren nach einem der vorstehenden Ansprüche, **dadurch gekennzeichnet, dass** die erfassten Stromwerte ausgewertet werden, um die elektrische Störung eines FETs (Q1) in der Treiberschaltung (14) zu lokalisieren und den elektrischen Widerstandswert des gestörten FETs (Q1) zu bestimmen.

6. Verfahren nach einem der vorstehenden Ansprüche, **dadurch gekennzeichnet, dass** die Ansteuerung mit dem Prüf-Schaltmuster bei hohen Rotorwinkelgeschwindigkeiten in Abhängigkeit vom elektrischen Winkel des Elektromotors (9) erfolgt, wobei der elektrische Winkel mittels eines Rotorlagesensors bestimmt wird.

7. Verfahren nach einem der vorstehenden Ansprüche, **dadurch gekennzeichnet, dass** bei niedrigen Rotorwinkelgeschwindigkeiten die Ansteuerung mit dem Prüf-Schaltmuster in Zeitabständen asynchron zu dem elektrischen Winkel des Elektromotors (9) erfolgt, wobei die Rotorwinkelgeschwindigkeit mittels eines Rotorlagesensors bestimmt wird.

8. Verfahren nach einem der vorstehenden Ansprüche, **dadurch gekennzeichnet, dass** innerhalb des Durchlaufens einer kompletten elektrischen Periode des Elektromotors (9) die Ansteuerung der Sicherheitsschalter (Q7, Q8, Q9) erfolgt.

9. Verfahren nach einem der vorstehenden Ansprüche, **dadurch gekennzeichnet, dass** eine Body-Diode der Sicherheitsschalter (Q7, Q8, Q9) in Durchlassrichtung oder in Sperrrichtung geschaltet ist.

10. Elektromechanische Kraftfahrzeuglenkung, mit einem mehrphasigen, permanent erregten Elektromotor (9), der über eine Steuereinheit (12) und Zuleitungen (19+, 19-) aus einem Gleichspannungsbordnetz eines Kraftfahrzeugs betreibbar ist, wobei der Elektromotor (9) mindestens drei Phasenwicklungen (u, v, w) aufweist, die über Leitungen mit einer Treiberschaltung (14) verbunden sind, wobei die Treiberschaltung (14) jede der Leitungen über jeweils einen ersten FET (Q1, Q3, Q5) einer ersten Gruppe mit der positiven Zuleitung (19+) und über jeweils einen zweiten FET (Q2, Q4, Q6) einer zweiten Gruppe mit der negativen Zuleitung (19-) in Abhängigkeit von der Ansteuerung der Steuereinheit (12) verbindet, und wobei jede Leitung einen FET (Q7, Q8, Q9) als Sicherheitsschalter aufweist, und die Steuereinheit (12) dazu ausgebildet ist, das Verfahren nach einem der Ansprüche 1 bis 9 auszuführen.

## Claims

1. Method for protecting safety switches (Q7, Q8, Q9) of a control unit (11) of an electric motor (9), the control unit (11) having a microcontroller (12) and a gate driver (13) which drive a driver circuit (14) with 2n FETs (Q1, Q2, Q3, Q4, Q5, Q6), where n is the number of phase windings (u, v, w) of the electric motor (9) and the FETs (Q1, Q2, Q3, Q4, Q5, Q6) are arranged in half bridges, and in the center tap of each half bridge, the safety switch (Q7, Q8, Q9) is arranged between the driver circuit (14) and the phase winding (u, v, w) of the electric motor (9), the safety switches (Q7, Q8, Q9) being FETs which are set up to interrupt the electrical connection between the driver circuit (14) and each phase winding (u, v, w) in the event of a fault, **characterized in that** the method comprises the following steps in the event of an electrical fault in the driver circuit (14):
a) Activate one of the 2n FETs (Q1, Q2, Q3, Q4, Q5, Q6) of the driver circuit (14),
b) Measuring the current flow in a supply line (19-) of the driver circuit (14) and detecting a current value,
c) Deactivate the activated FET (Q1, Q2, Q3, Q4, Q5, Q6) of the driver circuit (14),
d) successively executing a test switching pattern in accordance with steps a) to c) for the remaining 2n-1 FETs (Q1, Q2, Q3, Q4, Q5, Q6), all FETs being deactivated at the start of execution of the test switching pattern,
e) evaluating the detected current values with regard to falling below a predetermined threshold value, whereby the highest detected current value (22) is not taken into account,
f) if the value falls below the threshold value, disconnecting the electrical connection between the driver circuit (14) and at least one of the phase windings (u, v, w) by switching the safety switches (Q7, Q8, Q9),
whereby process steps a) to f) are carried out again if the value does not fall below the threshold value.

2. Method according to claim 1, **characterized in that** a predetermined time interval, in particular a time interval between 1 µs and 1 ms, lies between the activation of a FET (Q1, Q2, Q3, Q4, Q5, Q6) and the deactivation of this FET (Q1, Q2, Q3, Q4, Q5, Q6).

3. Method according to one of the preceding claims, **characterized in that,** when evaluating the detected current values, the second-highest current value (23) and the third-highest current value (24) are determined from the detected current values; a sum value is formed from the values of the second-highest current value (23) and the third-highest current value (24); and the sum value is compared with the predetermined threshold value during the evaluation.

4. Method according to one of the preceding claims, **characterized in that** the threshold value is dependent on the electrical properties of the safety switch (Q7, Q8, Q9).

5. Method according to one of the preceding claims, **characterized in that** the detected current values are evaluated in order to localize the electrical disturbance of a FET (Q1) in the driver circuit (14) and to determine the electrical resistance value of the disturbed FET (Q1).

6. Method according to one of the preceding claims, **characterized in that** the activation with the test switching pattern takes place at high rotor angular speeds as a function of the electrical angle of the electric motor (9), the electrical angle being determined by means of a rotor position sensor.

7. Method according to one of the preceding claims, **characterized in that,** at low rotor angular velocities, the activation with the test switching pattern takes place at time intervals asynchronously to the electrical angle of the electric motor (9), the rotor angular velocity being determined by means of a rotor position sensor.

8. Method according to one of the preceding claims, **characterized in that** the activation of the safety switches (Q7, Q8, Q9) takes place within the passage of a complete electrical period of the electric motor (9).

9. Method according to one of the preceding claims, **characterized in that** a body diode of the safety switches (Q7, Q8, Q9) is connected in the forward direction or in the blocking direction.

10. Electromechanical motor vehicle steering system, having a multiphase, permanently excited electric motor (9) which can be operated via a control unit (12) and supply lines (19+, 19-) from a DC vehicle electrical system of a motor vehicle, the electric motor (9) having at least three phase windings (u, v, w) which are connected via lines to a driver circuit (14), the driver circuit (14) connecting each of the lines via in each case a first FET (Q1, Q3, Q5) of a first group to the positive supply line (19+) and via in each case a second FET (Q2, Q4, Q6) of a second group to the negative supply line (19-) as a function of the control of the control unit (12), and wherein each line has a FET (Q7, Q8, Q9) as a safety switch, and the control unit (12) is designed to carry out the method according to one of claims 1 to 9.

## Revendications

1. Procédé de protection d'interrupteurs de sécurité (Q7, Q8, Q9) d'une unité de commande (11) d'un moteur électrique (9), l'unité de commande (11) comprenant un microcontrôleur (12) et un pilote de grille (13) qui commandent un circuit d'attaque (14) avec 2n FET (Q1, Q2, Q3, Q4, Q5, Q6), où n est le nombre d'enroulements de phase (u, v, w) du moteur électrique (9) et les FET (Q1, Q2, Q3, Q4, Q5, Q6) sont disposés en demi-ponts, et dans la prise centrale de chaque demi-pont, entre le circuit d'attaque (14) et l'enroulement de phase (u, v, w) du moteur électrique (9) est disposé l'interrupteur de sécurité (Q7, Q8, Q9), interrupteurs de sécurité (Q7, Q8, Q9) étant des FET adaptés pour interrompre la connexion électrique entre le circuit d'attaque (14) et chaque enroulement de phase (u, v, w) en cas de défaut électrique, **caractérisé en ce que** le procédé comprend les étapes suivantes en cas de panne électrique dans le circuit d'attaque (14):
a) Activer l'un des 2n FET (Q1, Q2, Q3, Q4, Q5, Q6) du circuit d'attaque (14),
b) mesurer le flux de courant dans une ligne d'alimentation (19-) du circuit d'attaque (14) et détecter une valeur de courant,
c) désactiver le FET activé (Q1, Q2, Q3, Q4, Q5, Q6) du circuit d'attaque (14),
d) l'exécution successive d'un motif de commutation de test selon les étapes a) à c) pour les 2n-1 FET restants (Q1, Q2, Q3, Q4, Q5, Q6), tous les FET étant désactivés au début de l'exécution du motif de commutation de test,
e) l'évaluation des valeurs de courant détectées par rapport à une valeur inférieure à une valeur de seuil prédéfinie, la valeur de courant détectée la plus élevée (22) n'étant pas prise en compte,
f) en cas de dépassement vers le bas de la valeur seuil, déconnexion de la liaison électrique entre le circuit d'attaque (14) et au moins l'un des enroulements de phase (u, v, w) par commutation des interrupteurs de sécurité (Q7, Q8, Q9),
les étapes de procédé a) à f) étant exécutées à nouveau si la valeur seuil n'est pas dépassée vers le bas.

2. Procédé selon la revendication 1, **caractérisé en ce qu'**entre l'activation d'un FET (Q1, Q2, Q3, Q4, Q5, Q6) et la désactivation de ce FET (Q1, Q2, Q3, Q4, Q5, Q6) se trouve un intervalle de temps prédéterminé, en particulier un intervalle de temps compris entre 1 µs et 1 ms.

3. Procédé selon l'une des revendications précédentes, **caractérisé en ce que,** lors de l'évaluation des valeurs de courant détectées, la deuxième valeur de courant la plus élevée (23) et la troisième valeur de courant la plus élevée (24) sont déterminées à partir des valeurs de courant détectées; une valeur de somme est formée à partir des valeurs de la deuxième valeur de courant la plus élevée (23) et de la troisième valeur de courant la plus élevée (24); et la valeur de somme est comparée à la valeur de seuil prédéterminée lors de l'évaluation.

4. Procédé selon l'une des revendications précédentes, **caractérisé en ce que** la valeur de seuil est fonction des caractéristiques électriques de l'interrupteur de sécurité (Q7, Q8, Q9).

5. Procédé selon l'une des revendications précédentes, **caractérisé en ce que** les valeurs de courant détectées sont évaluées pour localiser la perturbation électrique d'un FET (Q1) dans le circuit d'attaque (14) et pour déterminer la valeur de résistance électrique du FET (Q1) perturbé.

6. Procédé selon l'une des revendications précédentes, **caractérisé en ce que** la commande avec le motif de commutation de test est effectuée à des vitesses angulaires élevées du rotor en fonction de l'angle électrique du moteur électrique (9), l'angle électrique étant déterminé au moyen d'un capteur de position du rotor.

7. Procédé selon l'une des revendications précédentes, **caractérisé en ce que,** pour de faibles vitesses angulaires du rotor, la commande avec le motif de commutation de test est effectuée à des intervalles de temps de manière asynchrone par rapport à l'angle électrique du moteur électrique (9), la vitesse angulaire du rotor étant déterminée au moyen d'un capteur de position du rotor.

8. Procédé selon l'une des revendications précédentes, **caractérisé en ce que** la commande des interrupteurs de sécurité (Q7, Q8, Q9) est effectuée au cours d'une période électrique complète du moteur électrique (9).

9. Procédé selon l'une des revendications précédentes, **caractérisé en ce qu'**une diode de corps des interrupteurs de sécurité (Q7, Q8, Q9) est connectée dans le sens passant ou dans le sens bloqué.

10. Direction électromécanique de véhicule automobile, comportant un moteur électrique (9) polyphasé, excité en permanence, qui peut être actionné par l'intermédiaire d'une unité de commande (12) et de lignes d'alimentation (19+, 19-) à partir d'un réseau de bord à tension continue d'un véhicule automobile, le moteur électrique (9) comportant au moins trois enroulements de phase (u, v, w) qui sont reliés par l'intermédiaire de lignes à un circuit d'attaque (14), le circuit d'attaque (14) commandant chacune des lignes par l'intermédiaire respectivement d'un premier FET (Q1, Q3, Q5) d'un premier groupe à la ligne d'alimentation positive (19+) et par l'intermédiaire d'un deuxième FET (Q2, Q4, Q6) d'un deuxième groupe à la ligne d'alimentation négative (19-) en fonction de la commande de l'unité de commande (12), et dans lequel chaque ligne comprend un FET (Q7, Q8, Q9) en tant qu'interrupteur de sécurité, et l'unité de commande (12) est adaptée pour mettre en œuvre le procédé selon l'une des revendications 1 à 9.
